# EUROPEAN PATENT APPLICATION

(11) **EP 0 959 505 A2**
(43) Date of publication of application: **24.11.1999**
(21) Application number: 99201426.6
(22) Date of filing: 06.05.1999
(51) Int. Cl.: H01L 31/0216, H01L 27/146

(54) **Method for planarising the device topography on solid state imagers**

(30) Priority: 18.05.1998 US 80849
(71) Applicant: EASTMAN KODAK COMPANY, Rochester, New York 14650 (US)
(72) Inventor: Pace, Laurel J., Patent Legal Staff, Rochester, New York 14650-2201 (US); Murphy, Cynthia M., Patent Legal Staff, Rochester, New York 14650-2201 (US); Erhardt, Herbert J., Patent Legal Staff, Rochester, New York 14650-2201 (US); Hanrahan, Michael J., Patent Legal Staff, Rochester, New York 14650-2201 (US); Ewbank, Dale E., Patent Legal Staff, Rochester, New York 14650-2201 (US)
(74) Representative: Lewandowsky, Klaus, Dipl.-Ing.

(57) **Abstract**

An improved and simplified process for reducing the topography within a solid state imager by using a single coat, expose, and development sequence to produce a transparent layer that fills in the topographic features surrounding the photoactive area while also planarizing the photoactive area. The topography within an imaging device is reduced by application of a transparent patternable layer to a semiconductor substrate having a plurality of image sensors with topographic features including structures in the photoactive area and in the periphery around the photoactive area including metal wiring and bond pads followed by a patterning step of this first layer by patternwise activating exposure. The result after pattern development is that the transparent layer is removed only from those areas with topographic features that are substantially higher than the surrounding area and the bond pads. This layer also remains over the photoactive area to serve as a planarizing layer. At this point, a CFA and/or lenslets may be formed over the photoactive area and the uniformity of the coating will be substantially improved over the uniformity obtained using planarizing layers within the prior art.

## Description

### FIELD OF THE INVENTION

This invention relates to a method for reducing the magnitude of topography on solid state image sensors as well as providing a planarizing layer over the photoactive area.

### BACKGROUND OF THE INVENTION

Solid state images sensors are comprised of a grid of laterally spaced sensor elements, each of which is called a "pixel". Each pixel in the sensor includes a photosensor such as a photodiode or photocapacitor. In operation, light impinging on an active silicon region in the pixel results in the generation of a charge which can be read and used to construct a digital image. Semiconductor arrays including sensor elements of this type are usually prepared by sequential patterning of conductors, semiconductors and insulators. These patterned layers introduce topography in and around the image sensor.

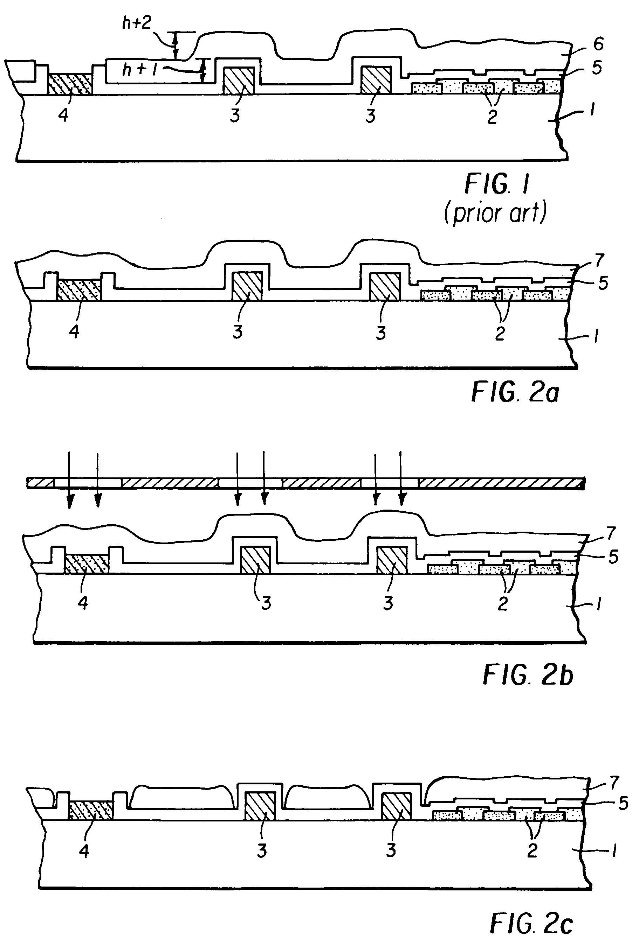

Silicon photosensors in these devices are sensitive to a wide bandwidth of radiation including the visible spectrum. However, in order to separate the light into colored components, color separation inputs are required. This color separation can be achieved in a variety of ways, but most typically it is achieved by constructing a color filter array (CFA), which is an array of dyed patterns which are in registration with the underlying photosensor array. The final intensity and uniformity of an image that is produced by an image sensor device is strongly dependent upon the thickness and uniformity of the coating that is used to make the CFA. When the CFAs are coated using a spin coating process, the topography that surrounds the photosensitive area can disrupt the flow of the coating material to such a degree that coating defects, called streaks or tails, are produced. The conventional approaches for addressing this problem are threefold:
1) to "fill in" any very deep topographic feature and ten to coat a "planarizing" layer (also called a smoothening layer or flattening layer), prior to CFA fabrication. This requires multiple coating and patterning steps. In addition, the prior art is primarily directed toward filling in deep recesses in the substrate (i.e., Scribe lines).
2) to coat a planarizing layer over all topographic features and to just remove this layer from over the bond pads. In general, planarizing layers for solid state imagers consist of a coating that covers all areas in and around the photoactive area except for the bond pads and, in some cases, the scribe area (layer 6 in Figure 1). This has the disadvantage that most spin coatings are conformal so that the overall reduction in topography, especially for very high features, is limited (compare ht 1 with ht 2) so the coating non-uniformity introduced by the topography is not greatly reduced.
3) to blanket the entire chip area with a filling material this is then either etched back or smoothed by chemical mechanical polishing (CMP) to polish the surface prior to CFA fabrication. This approach is more process intensive than a single spin coating and has the potential to introduce large step heights around the bond pads as well as introducing a large separation between the CFA and the photoactive area.

Examples of the prior art techniques are found in the following references:

In the area of "filling in" recessed portions, U.S. Patent 4,665,010, Herd et al, 1987 "Method of Fabricating Photopolymer Insolation Trenches in the surface of a Semiconductor Wafer" describes a technique for filling isolation trenches by coating a photopolymer, patterning it over the trench, and then applying heat to shrink the polymer until it is coplanar with the substrate surface. U.S. Patent 5,135,891, Ikeno et al, 1992, "Method of Forming Film of Uniform Thickness on Semiconductor Substrate Having Concave Portion" describes a method for filling in concave features on a semiconductor device. The method consists of coating a first material that is selectively removed from all regions but the concave structure. This selective removal is accomplished by applying a photosensitive film on this first material, patterning this photosensitive film, and then etching the first material using the patterned photosensitive material as the mask. In one case, a smoothening layer is then coated prior to coating color filters. U.S. Patent 5,155,060, Ikeno et al, 1992 "Method for Forming Film of Uniform Thickness on Semiconductor Substrate Having Concave Portion" describes applying a first material that is removed from all areas but the scribe line, followed by formation of a planarizing layer on which color filters are formed. U.S. Patent 5,404,005, Shimomura et al, 1995, "Solid State Imaging Device and Method of Manufacturing Same" describes a method for smoothing the surface of a solid state imaging device by forming a "gap filler" layer in the scribe lines and sometimes the bond pads, a transparent "gap filler" layer in the photosensitive section of each pixel, and then a transparent "flattening" layer over the entire substrate prior to the fabrication of CFAs. U.S. Patent 5,426,058, Nakai et al, 1995, "Method of Manufacturing Solid State Imaging Device" describes a method for smoothing the surface of a solid state imaging device by embedding a thermosoftening polymeric material in recessed portions of the substrate (specifically scribe lines). This can be followed by application of a second polymeric material to form a smooth continuous film (planarizing layer).

In the area of coating a planarizing layer over all features and removing it from just the bond pads and sometimes the scribe lines, U.S. Patent 5,654,202, Daly and Blood, 1992 "Stabilization of a Patterned Planarizing Layer for Solid State Imagers Prior to Color Filter Pattern Formation" describes a planarizing layer that is incorporated prior to CFA fabrication in order to provide a smooth uniform surface for coating and adhesion. A planarizing layer is applied over all topographic features, removed from over the bond pads, stabilized, and then coated with color filters.

In the area of polishing or etching back a support layer, U.S. Patent 5,719,074, Hawkins et al, 1998, "Planar Color Filter Array from Dyed and Mordant Layers" describes a substrate wit a support layer that has an optically planar surface formed by chemical mechanical polishing on which a CFA is formed.

### SUMMARY OF THE INVENTION

The object of this invention is to simplify the previously discussed prior art processes for reducing the topography within a solid state imager by using a single coat, expose, and development sequence to produce a transparent layer that fills in the topographic features surrounding the photoactive area (i.e., metal wiring) while also planarizing the photoactive area.

The present invention provides a simplified process for reducing the topography within an imaging device by application of a transparent patternable layer to a semiconductor substrate having a plurality of image sensors with topographic features including structures in the photoactive area and in the periphery around the photoactive area including metal wiring and bond pads followed by a patterning step of this first layer by patternwise activating exposure. Either a positive-working resist system or a negative-working system may be used. The result after pattern development is that the transparent layer is removed only from those areas with topographic features that are substantially higher than the surrounding area. This layer also remains over the photoactive area to serve as a planarizing layer. At this point, a CFA and/or lenslets may be formed over the photoactive area and the uniformity of the coating will be substantially improved over the uniformity obtained using planarizing layers within the prior art.

These and other features of the invention are provided in a method for planarizing a wafer containing solid state image sensors comprising the steps of: providing a wafer having a plurality of semiconductor imaging devices, each of the devices having a photoactive area with a first set of topographic features within the photoactive area and a non-photoactive area with a second set of topographic features, such that the photoactive area is surrounded by the second set topographic features; coating the wafer with a transparent photosensitive layer; and patterning photosensitive layer by patternwise activating exposure and pattern development such that the transparent photosensitive layer is removed at least from a portion of the second set of features and remains over the photoactive area.

### ADVANTAGES OF THE INVENTION

The present invention teaches a process capable of creating more planar surfaces for solid state image sensors with a minimal number of process steps required. The resulting sensor is of a higher quality at a reduced cost.

### BRIEF DESCRIPTION OF THE DRAWINGS

Fig. 1 illustrates a planarizing layer as typically existing within prior art devices;
Fig. 2a shows the application of a transparent patternable layer to a semiconductor substrate;
Fig. 2b shows the patterning of this first layer by patternwise activating exposure;
Fig. 2c shows the result after pattern development where the transparent layer is removed only from those areas with topographic features that are substantially higher than the surrounding area.
Fig. 3 shows the result after application of a color filter array on top of the patterned transparent layer and in registration with the underlying photoactive area.
Fig. 4 shows the result after application of a lenslet array array on top of the patterned transparent layer and in registration with the underlying photoactive area. The lenslet array may be applied with or without a color filter array underneath. The lenslet array may be applied with or without a second transparent layer underneath which serves to determine the focal distance between the lenslet and the photoactive area.
Fig. 5a shows the patterning of a first transparent layer by patternwise activating exposure.
Fig. 5b shows the result after pattern development where the transparent layer is removed only from those areas with topographic features that are substantially higher than the surrounding area; the area over the bond pads is not patterned.
Fig. 5c shows the result after application of a color filter array on top of the patterned transparent layer and in registration with the underlying photoactive area.
Fig. 5d shows the application of a second transparent patternable layer.
Fig. 5e shows the patterning of both the first and second transparent layers by patternwise activating exposure.
Fig. 5f shows the result after pattern development where both transparent layers are removed from the area over the bond pads.

### DETAILED DESCRIPTION OF THE INVENTION

The object of this invention is to simplify the process of reducing topography on a solid state imager by using a single coat, expose, and development sequence to produce a transparent layer that fills in the topographic features surrounding the photoactive area (i.e., metal wiring) while also planarizing the photoactive area.

Referring to Figure 1, there is shown a cross-sectional view of a prior art image sensor. This image sensor comprises a semiconductor substrate 1 having a plurality of image sensors with topographic features 3 including structures in the photoactive area 2 and in the periphery around the photoactive area 2 including topographic features such as metal wiring 3 and bond pads 4. A majority of the topographic features is covered by a passivation layer 5. The planarization layer 6 is coated over the entire surface of the sensor and is removed only from the area of the bond pad 4. The planarization layer 6 may also be removed from the scribe area (not shown).

The preferred processing sequence in accordance with the present invention, shown in Figure 2a through 2c, provides a substantial improvement over the prior art planarizing layer 6 as seen in Fig. 1.

Fig. 2a shows the application of a transparent patternable planarizing layer 7 to semiconductor substrate 1. Specific thickness of the coating used to make planarizing layer 7 is dictated by considerations relating to the height of the topographic features on the wafer. Solvent present in the coating may then be removed by baking, thereby resulting in enhanced adhesion and maximization of the planarity of the surface. An optimum thickness has been found to correspond with a range of 0.5 to 2.0 micrometers.

Fig. 2b shows the patterning of this planarizing layer 7 by patternwise activating exposure. While a positive-working resist system is shown in Fig. 2b, a negative-working system may also be used. The planarizing layer 7 so deposited is subjected to imagewise exposure and development.

Various options exist for completion of the planarizing layer. More specifically, the materials chosen for use as the planarizing layer 7 and the process employed for opening the device bonding pads 4 for connection to external electronic circuitry dictates the procedure to follow. Thus, for example, it may be advantageous to generate openings down to the bonding pads 4, particularly if the planarizing layer is a photosensitive composition or if a photoresist is coated upon the planarizing layer. Materials useful in the former include formulations capable of photoinitiated polymerization, photocrosslinking, photodimerization, light induced scission and photofunctional change. In each case, the patternwise exposure of the coating creates differences in the dissolution properties of the coating. Many well known polymers and formulations may be used as photoresists for this purpose and they may be used directly as a planarizing layer or upon the planarizing layer 7. Further information may be found by reference to "Photoreactive Polymers: The Science and Technology of Resists". Arnost Reiser, John Wiley and Sons, Inc., N.Y. 1989.

Figure 2 c shows the result after pattern development where the transparent layer is removed only from those areas with topographic features that are substantially higher than the surrounding area. This layer also remains over the photoactive area to serve as a planarizing layer. The edge of the patterned transparent layer may be offset from the edge of the topographic features (as shown in Fig. 2c) or alternatively, the edge of the patterned layer may overlap slightly onto the edge of the topographic features. The patterned layer may be subjected to a high temperature step in order to cause it to flow and to fill in more evenly.

In a planarizing layer which functions as a negative photosensitive material, the exposed areas become less soluble in developer. Masked exposure permits all of the coating except the coating above the bonding pads and the high topographic features to be exposed to light. As a result, the exposed areas become less soluble in the developer. Development then removes the coating from atop the bonding pads and the high topographic features, thereby permitting connection to an external electrical circuit. Chemical functionality which may serve as the photosensitive element for resists of this type include the azide and diazonium compounds. The azides decompose upon exposure to form nitrenes which are highly reactive with a variety of organic molecules. Imaging systems which are useful as planarizing layers can be formulated from either mono or bisazides which absorb at the exposure wavelength and are within a polymer matrix such as novolac, cyclized polyisoprene or polyhydroxystyrene which have sites that are reactive with nitrenes. Multiple insertion, abstraction and addition reactions of the nitrenes on the polymer chain result in crosslinking of the exposed area. In light of the fact that a crosslinked area cannot dissolve, a negative image is formed by treating the exposed wafer with a solvent for the original coating. Imaging with a diazonium salt or a diazo resin occurs by altering the solubility of the exposed areas without effecting crosslinking. The coating solution for this type of planarizing layer includes an organic diazonium salt and a water soluble polymer in water. Polymers suitable for this purpose include gelatin, polyvinyl alcohol, polymers containing quaternary ammonium salts and poly (vinyl pyrrolidone). Upon exposure at an appropriate wavelength, the diazonium salt eliminates nitrogen and becomes non-ionic and, therefore, insoluble in water. This photofunctional change acts to inhibit the dissolution of the exposed areas and results in a negative image after development with some crosslinking occurring.

Polymers, such as poly(vinyl cinnamate), which contain photodimerizable chromophores provide another useful class of negative imaging planarizing layers suitable for use in the practice of the present invention. In such cases, the reactive chromophore must contain a group which can dimerize by a 2+2 photocyclization. Representative groups include cinnamate, styrylacrylate, napthylacrylate and thiofurylacrylate. These polymers are typically prepared by reacting poly(vinyl alcohol) with the corresponding acid chloride. Useful polymers may also be prepared for this purpose by modification of polystyrene or poly(chloromethylstyrene) with an acid chloride or an amine bearing chromophores. Dimerization may then be effected by direct exposure or by sensitization with either triplet or electron transfer sensitizers.

Still another class of materials suitable for use as a planarizing layer are the photoinitiated polymerization imaging systems. In such systems, light is absorbed by a compound which breaks down to form a reactive species which initiates the polymerization of monomers. These initiators are typically chosen to produce either a free radical or a cation. The free radical rapidly polymerizes acrylates and methacrylates to yield a high polymer. Since the monomer dissolves in many more solvents than the polymer and does so rapidly, a negative image mask is obtained after exposure and development. Cationic polymerization of epoxides yield the same results. Suitable free radical photoinitiators for this purpose include peroxides, azo compounds, benzoin ethers and ketocoumarins with amino accelerators. Photoresponsive cationic initiators include diazonium, iodinium and sulfonium salts. The optimum results are obtained with multifunctional monomers. Since the monomer serves as a coating solvent and is polymerized rather than removed, this system yields a more planar system.

Positive imagable systems, which become more soluble in the developer upon exposure, may also be used as planarizing layer. These systems function in accordance with one of two mechanisms, namely, photofunctional change or scissioning. Thus, for example, poly(methyl methacrylate) is a polymer which undergoes scissioning during exposure at an appropriate wavelength. In this process, the polymer backbone is broken, so reducing the molecular weight of the polymer. Since the dissolution rate for a polymer composition varies significantly and inversely with the molecular weight of the polymer, the rate of dissolution increases as the molecular weight decreases. Accordingly, during the development sequence, the exposed areas are removed rapidly to yield a positive image. Other scissioning polymers include poly(methylisopropenylketone), poly(dimethylglutarimide) and poly(nonafluorobutyl-methacrylate).

Photofunctional change resists based upon a naphthalenequinone diazide compound produces positive images after exposure and development without changing the molecular weight of the polymer. Resists of this type include two principle components, a photoactive compound and a binder polymer which is soluble in an aqueous base. The naphthalenequinone diazide photoactive compound inhibits the dissolution of the polymer binder in an aqueous base. Upon exposure to light, the quinone is destroyed and the photoproduct becomes a dissolution accelerator for the binder in an aqueous base. The result of this exposure followed by development again leads to a positive image. Binders useful for this type of imagable planarizing layer include novolac resins and polyhydroxystyrene.

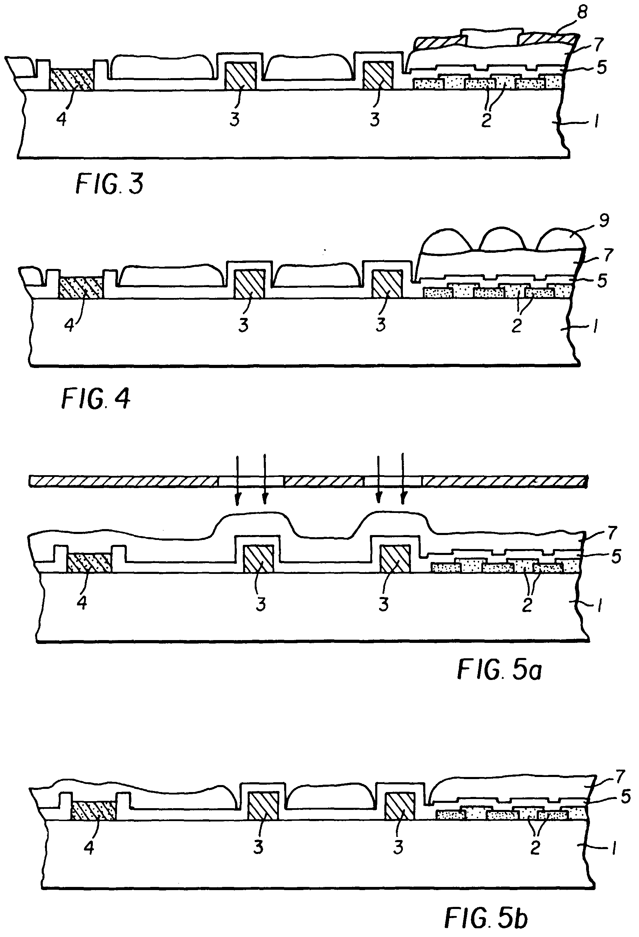

At this point, a color filter array 8 as seen in Figure 3 and/or lenslets 9 as seen in Figure 4 may be formed over the photoactive area and the uniformity of the coating will be substantially improved over the uniformity obtained using the planarizing layer as shown in Figure 1. One common approach to forming color filter layers is by a photopatterning, dye imbibition process in which hydrophilic colloids are suspended in water along with a radiation responsive hardening (i.e.,crosslinking) agent. These aqueous solutions can then be coated to form photopatternable filter layers. Suitable hydrophillic colloids for this purpose include substances such as proteins, protein derivatives, cellulose derivatives and polysaccharides such as cellulose esters, gelatin (alkali or acid treated), gelatin derivatives such as acetylated gelatin and phthalated gelatin, dextren, gum arabic, zein, casein, pectin, collagen derivatives, collodion, agar-agar, arrowroot and albumin, all generally known to be useful as binders in photographic elements. The hydrophillic colloid, preferably gelatin or a gelatin derivative, can be conveniently employed in combination with a dichromate salt, employed as a radiation responsive hardening agent. The dichromate salt is, for example, potassium, sodium or ammonium dichromate. Dichromated gelatin has sufficient resolution for the filter elements of the color filter arrays for solid state imaging devices. It adheres well and is conveniently coated and developed using water solutions. Gelatin and related hydrophillic colloids are known to exhibit some capacity for mordanting cationic dyes. Thus, relatively simple filter layer constructions are possible. It is, of course, recognized that conventional mordants can, if desired, be employed in combination.

The transparent patternable planarizing layer 7 can be removed from the bond pads either before or after CFA fabrication. The transparent patternable planarizing layer 7 can also be removed from the scribe area if desired. This can be done either before or after CFA fabrication. In order to remove the patternable layer from the bond pads and other areas after CFA fabrication, a second preferred processing sequence in accordance with the present invention, shown in Figure 5a through 5f, may be used.

Fig. 5a shows the patterning of a positive-working transparent resist as planarizing layer 7 by patternwise activating exposure. The planarizing layer 7 so deposited is subjected to imagewise exposure and development.

Figure 5b shows the result after pattern development where the transparent planarizing layer 7 is removed only from those areas with topographic features that are substantially higher than the surrounding area. The planarizing layer 7 remains over the bond pads and may remain over the scribe area (not shown). This layer also remains over the photoactive area to serve as a planarizing layer.

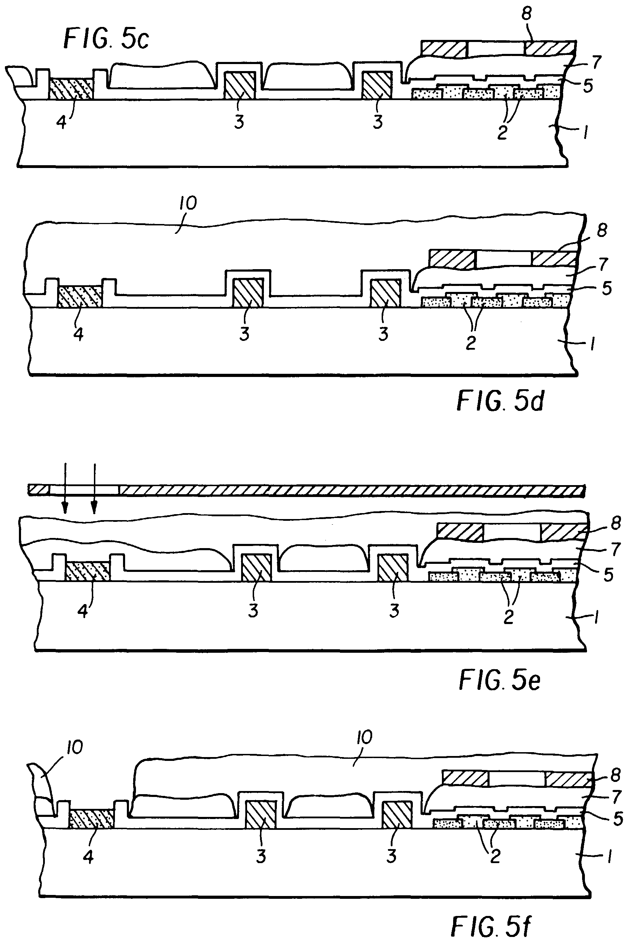

After the application of color filter arrays (Figure 5c), a second positive-working transparent resist layer 10 is applied as shown in Figure 5d. This layer may be of the same or different composition from that of transparent resist planarizing layer 7.

Figure 5e shows the patternwise exposure of both transparent resist layers 7 and 10 such that both layers are removed from the area around bond pads 4 after pattern development (Figure 5f). Both layers may also be removed from other areas surrounding the photoactive area such as the scribe line.

If a planarizing layer is not desired, then the first (and/or second) color filter coating can serve a similar smoothing function for subsequent layers if it is patterned so that it is removed from all of the high topographic points surrounding the photoactive area.

Other aspects of the invention include:
1). The method further comprising the step of depositing a color filter array on the transparent layer over the photoactive area.
2). The method further comprising the step of creating lenslets on the transparent layer over the photoactive area.
3). A method for fabrication of a color filter array on a wafer containing solid state image sensors comprising the steps of:
   providing a wafer having a plurality of semiconductor imaging devices, each of the devices having a photoactive area with a first set of topographic features within the photoactive area and a non-photoactive area with a second set of topographic features, such that the photoactive area is surrounded by the second set topographic features;
   coating the wafer with a transparent photosensitive layer;
   patterning the photosensitive layer by patternwise activating exposure and pattern development such that the transparent photosensitive layer is removed at least from a portion of the second set of features and remains over the photoactive area; and
   depositing a color filter array on the transparent layer over the photoactive area.
4). The method wherein the step of patterning further comprises removal of the transparent layer from a small region surrounding the photoactive area.
5). The method wherein the step of patterning the photosensitive layer by patternwise activating exposure and pattern development such that the transparent photosensitive layer is removed at least from a portion of the second set of features further comprises patterning and removal of a small region around a select set of individual features.
6). The method wherein the step of patterning further comprises forming an overlap of the transparent photosensitive layer on top of a small section of the region surrounding the photoactive area.
7). The method wherein the step of patterning the photosensitive layer by patternwise activating exposure and pattern development such that the transparent photosensitive layer is removed at least from a portion of the second set of features further comprises overlapping of the transparent photosensitive layer over a small region around a select set of individual features.
8). The method wherein the transparent layer is a positive-type photoresist.
9). The method wherein the transparent layer is a negative type photoresist.
10). The method wherein the transparent photosensitive layer is removed from additional portions of the second set of features after color filter array deposition by the following steps:
   coating a second positive-type photosensitive polymer after the completion of the color filter array; and
   patterning both photosensitive layers simultaneously by patternwise activating exposure and pattern development such that the first transparent layer is removed from additional portions of the second set of features.
11). The method wherein an array of microlenses is deposited on the second positive-type photosensitive polymer.
12). The method wherein the transparent photosensitive layer is removed from additional portions of the second set of features after color filter array deposition by the following steps:
   coating a second positive-type photosensitive polymer after the completion of the color filter array;
   patterning the second photosensitive layer by patternwise activating exposure and pattern development; and
   transferring the pattern into the first photosensitive layer.
13). A method for fabrication of a lenslet array on a wafer containing solid state image sensors comprising the steps of:
   providing a wafer having a plurality of semiconductor imaging devices, each of the devices having a photoactive area with a first set of topographic features within the photoactive area and a non-photoactive area with a second set of topographic features, such that the photoactive area is surrounded by the second set topographic features;
   coating the wafer with a transparent photosensitive layer;
   patterning the photosensitive layer by patternwise activating exposure and pattern development such that the transparent photosensitive layer is removed at least from a portion of the second set of features and remains over the photoactive area; and
   depositing an array of microlenses on the transparent layer over the photoactive area.
14). The method wherein the step of patterning further comprises removal of the transparent layer from a small region surrounding the photoactive area.
15. The method wherein the step of patterning the photosensitive layer by patternwise activating exposure and pattern development such that the transparent photosensitive layer is removed at least from a portion of the second set of features further comprises patterning and removal of a small region around a select set of individual features.
16). The method wherein the step of patterning further comprises overlap of the transparent photosensitive layer on top of a small section of the region surrounding the photoactive area.
17). The method wherein the step of patterning the photosensitive layer by patternwise activating exposure and pattern development such that the transparent photosensitive layer is removed at least from a portion of the second set of features further comprises overlapping of the transparent photosensitive layer over a small region around a select set of individual features.
18). The method wherein the transparent layer is a positive-type photoresist.
19). The method wherein the transparent layer is a negative type photoresist.
20). The method wherein the transparent photosensitive layer is removed from additional portions of the second set of features by the following steps:
   coating a second positive-type photosensitive polymer; and
   patterning both photosensitive layers simultaneously by patternwise activating exposure and pattern development such that the first transparent layer is removed from additional portions of the second set of features.

The foregoing description details the best modes known to the inventors for practicing the invention. Modifications of these best modes will be obvious to those skilled in the art, accordingly the scope of the invention should be measured by the appended claims.

### PARTS LIST

- 1: substrate
- 2: photoactive area
- 3: metal wiring
- 4: bond pads
- 5: passivation layer
- 6: planarization layer
- 7: planarization layer
- 8: color filter array
- 9: lenslets
- 10: transparent layer

## Claims

1. A method for planarizing a wafer containing solid state image sensors comprising the steps of:
providing a wafer having a plurality of semiconductor imaging devices, each of the devices having a photoactive area with a first set of topographic features within the photoactive area and a non-photoactive area with a second set of topographic features;
coating the wafer with a transparent photosensitive layer; and
patterning the photosensitive layer by patternwise activating exposure and pattern development such that the transparent photosensitive layer is removed at least from a portion of the second set of features and remains over the photoactive area.

2. The method of claim 1 wherein the step of patterning further comprises removal of the transparent layer from a small region surrounding the photoactive area.

3. The method of claim 1 wherein the step of patterning the photosensitive layer by patternwise activating exposure and pattern development such that the transparent photosensitive layer is removed at least from a portion of the second set of features further comprises patterning and removal of a small region around a select set of individual features.

4. The method of claim 1 wherein the step of patterning further comprises overlap of the transparent photosensitive layer on top of a small section of the region surrounding the photoactive area.

5. The method of claim 1 wherein the step of patterning the photosensitive layer by patternwise activating exposure and pattern development such that the transparent photosensitive layer is removed at least from a portion of the second set of features further comprises overlapping of the transparent photosensitive layer over a small region around a select set of individual features.

6. The method of claim 1 further comprising the step of applying a heat treatment to enable the patterned transparent layer to flow and smooth as a result of heat.

7. The method of claim 1 wherein the transparent layer is a negative type photosensitive polymer.

8. The method of claim 1 wherein the transparent layer is a positive type photosensitive polymer.

9. The method of claim 1 wherein the step of patterning the photosensitive layer by patternwise activating exposure and pattern development further comprises actinic radiation having a wavelength range between 200 and 300 nanometers.

10. The method of claim 1 wherein the step of patterning the photosensitive layer by patternwise activating exposure and pattern development further comprises actinic radiation having a wavelength range between 300 and 500 nanometers.
